# EUROPEAN PATENT APPLICATION

(11) **EP 3 098 032 A1**
(43) Date of publication of application: **30.11.2016**
(21) Application number: 15169169.8
(22) Date of filing: 26.05.2015
(51) Int. Cl.: B25J 7/00, B81C 99/00, G02B 21/32

(54) **MICRO GRIPPER WITH FORCE SENSOR**

(71) Applicant: Tampere University Of Technology, 33720 Tampere (FI)
(72) Inventor: Saketi, Pooya, 33720 Tampere (FI); Kallio, Pasi, 33820 Tampere (FI)
(74) Representative: WSL Patentanwälte Partnerschaft mbB

(57) **Abstract**

The invention is related to a micro handling device for handling micro objects and for measuring forces exerted on said micro objects, including a micro gripper and a force sensor connected to said micro gripper, In order to provide such handling device which is rather simple and rugged in construction, less expensive than other typical devices used for such purpose and still useful and easily adaptable in measuring linear forces in the range of 10 µN to 1000 mN under relative displacements up to 1 mm or more, the device being applicable to a wide area of materials and components having micro-scale dimensions the present invention proposes that the device comprises a micro spring as the force sensor.

## Description

The present invention is related to a micro handling device handling micro objects and measuring forces exerted on said micro objects, including a micro gripper and a force sensor connected to said micro gripper

Typically such micro springs handling device may be used for gripping micro objects and exerting and measuring forces applied to said objects, wherein said micro objects have micro scale dimensions, such as micro fibers

By "micro scale dimensions" the present description is referring to minimum dimensions below 5 mm and in particular below 1 mm, i.e. in the micro meter range. I. e., it is sufficient if at least one dimension of an object is in such order of magnitude to be considered a "micro scale object" while other dimensions may be larger. For instance a microfiber is an object having a thickness which may be well below 100 µm or even below 10 µm, while the length of such microfiber may have macroscopic dimensions such as some centimeters or even meters. Still, if such microfiber is to be grasped or may even have to be inserted through a correspondingly small orifice, it would have to be considered as a micro scale object according to the present invention, because the micro scale thickness would be relevant for handling such object in a particular application. This may also apply to thin films or other objects such as micro particles or even nanoparticles once they need to be handled, grasped and/or tested, for instance with regard to their mechanical properties such as tensile strength, elastic properties etc.

In particular, the present invention is related to devices which are capable to exert and measure small tensile or compression forces (typically below 1 N) acting on or exerted by materials and components on micro scale dimensions.

Micro-tensile testers are already known in the art and they are required mainly in two application areas, namely characterizing materials and components used for fabricating-electro-mechanical systems (MEMS) and characterizing micro scale specimens of various materials such as micro-scale fibers.

Micro scale fibers do not need high forces for manipulation, but some fibers such as paper fibers and CNTs require relatively high forces for tensile testing and mechanical characterization. These forces are not necessarily in the micro scale force range and can be as high as 1 N.

The devices used for micro-tensile testing are in three categories:
i) commercialized universal micro-testing machines which are using load cells,
ii) atomic force microscopes (AFM)s with special cantilevers, and
iii) micro-tensile testers developed for specific application areas by utilizing micro-electromechanical technologies. Such micro-electromechanical technologies are typically involved with lithographic techniques originally developed for the preparation of semiconductor devices such as transistors and integrated circuits.

An interferometric strain/displacement measurement system, which measures the strain using a laser sensor and measures the force using a load cell, was developed in national aeronautic and space administration (NASA) and reported in 1983 by W. N. Sharpe Jr. "An interferometric strain/displacement measurement system", 1989.

Another load cell based micro-tensile tester, which was used for in-situ AFM measurements, was reported in 2006 (E. Bamberg, et al., Precis Eng, vol. 30, pp. 71-84, 1, 2006.) . The reported resolution for this device was 125 mN for the force range of 25 N. Besides commonly used load cells, other technologies have been developed for high resolution micro-tensile testing. A micro-tensile testing system, for sub-micrometer thick films, was developed using a servo controlled balance with 100 mN force range and 1µN resolution (T. Tsuchiya et al.:Sensors and Actuators A: Physical, vol. 97-98, pp. 492-496, 4/1, 2002).

In order to measure the tensile strength of free standing thin films, an eddy-current displacement sensor and two steel flex stripes were used to fabricate a micro-tensile tester with 12 mN force range (Y. Cheng, et al. Thin Solid Films, vol. 484, pp. 426-432, 7/22, 2005).

In another approach, micro-tensile testers utilizing a bender as the force sensing component were also reported; e.g. a silicon beam bender for studying the micromechanics of polymers (U. Lang et al., Microelectronic Engineering, vol. 83, pp. 1182-1184, 0, 2006), and a deflectable pipette for viscoelastic analysis of muscle cells (K. Nagayama et al. Med. Eng. Phys., vol. 29, pp. 620-628, 6,2007). In order to characterize the material properties of nanostructures, e.g. nanowires, a tensile testing system for in-situ electron microscopy strength measurements was developed (Y. Zhu and H. D. Espinosa, Proceedings of the National Academy of Sciences of the United States of America, vol. 102, pp. 14503-14508, October 11, 2005). This system consists of an electrostatic comb drive actuator for loading the specimen and a thermal actuator for displacement control. A differential capacitive comb structure was integrated into the system as the force sensing component with the resolution of 12 nN and the force range of 1.5 mN.

The existing devices for handling objects with micro scale dimensions and determining mechanical properties thereof are suffering from various drawbacks wherein one of these drawbacks may for instance be the narrow range of relative movement in which they can be used (i. e. the distance of any relative movement between stationary and moveable parts). In particular load cells which may use strain gauges, piezoelectric elements, and variable capacitance devices, provide a rather limited range of relative displacement in the micro meter range for a given range of forces and pathways along which a force may be applied to a moveable object.

While micro springs are principally known in the art, they have not yet found a wide range of application or practical use. While micro springs may have been used in some micro machines for providing any biasing force, they have not yet been used as force sensors. This may partly be due the delicate handling of micro springs or due a limited range of linearity of the known micro springs in terms of their range of extension and/or forces. In particular, no handling devices for micro scale objects appear to be known in the art which are using elastically deformable elements which may be referred to as "springs" in that they comprise a rather small stress/strain ratio and thereby allow the measurement of small forces over a rather long range of extension up to 1 mm or more.

A "spring" as used in the present description is defined as a device which may be extended or compressed, wherein, when starting out from an unbiased position, the amount of linear extension or compression, i.e. the change of length between two distant points, in particular the two ends of the spring, is proportional to the force acting on the spring according to Hook's law, so that the change of length can be taken as a direct measurement of the force.

Moreover, existing devices for handling and characterizing specimens by means of micro gripping and tensile testing are particularly complicated and expensive and many of them are less suited in the particular range of forces from some tens of µN up to about 1 N.

Accordingly, it is the object of the present invention to provide a device for handling and characterizing materials and components according to the preamble of claim 1, which is rather simple and rugged in construction, less expensive than other typical devices used for such purpose and still useful and easily adaptable in measuring linear forces in the range of 10 µN to 1000 mN under relative displacements up to 1 mm or more, the device being applicable to a wide area of materials and components having micro-scale dimensions.

This object is achieved by means of a device as defined in claim 1, which is comprising a micro spring as the force sensor.

As used in the present description the term "micro spring" refers to an element having elastic properties and being expandable and/ or compressible along at least one direction where an elastic repelling or retracting force is generated by the spring.

For applying or measuring forces, the ends of such spring may for instance be attached to a micro scale object and a stationary member, respectively.

A preferred embodiment of the present micro handling device comprises:
- a micro gripper attached to a slide, the slide being linearly moveable with respect to a carrier
- a micro spring as defined above and having two ends, one end attached to the micro gripper and the other end attached to the carrier, an imaginary line connecting the ends of the spring extending along the direction of linear movement of the slide, and
- a measuring device measuring a relative displacement between the micro gripper with respect to the carrier upon any force acting on the micro gripper along the direction of relative displacement, wherein the amount of displacement from an idle position is an indication of the force exerted on the micro gripper.

The relevant dimension to be measured for determining tensile forces acting on the spring is the elongation of the micro spring, i. e. the amount by which the spring is extended when starting from an unbiased or idle position (c.f. Hook's law). Accordingly with such arrangement, once one end of the micro spring has a fixed position in relation to a carrier and the other end of the spring is fixed in relation to the slide or the micro gripper fixedly mounted thereon, such extension can be directly measured as a relative displacement between carrier and slide.

In one embodiment, the spring is comprised of a chain of interconnected closed loops arranged in a common plane. The loops are connected and in contact with each other, while in a further embodiment, bridges are extending between adjacent loops and connect the same, wherein the bridges are formed preferably of the same material and may have the same cross section as the material forming the loops.

The loops may have an elliptical shape. In one embodiment, in particular for measuring tensile forces, the shorter axis should be aligned along the longitudinal direction of the chain of loops and the longer axis of the elliptical shape transverse to the longitudinal direction of the chain of loops. The longitudinal direction is the same direction as an imaginary line connecting the two ends of the spring, on which ends means may be provided for engaging a stationary part such as the carrier and a moveable part, such as the slide, respectively.

In one embodiment, the loops are formed by wires having a cross section having both, axial and radial dimensions of this cross section from between 10 to 100 µm.

Each of the loops is defining a plane and consists of a wire the cross section of which is defined by its radial and axial dimensions. The radial dimension of the wire forming the loop is to be measured along either of the axes of the elliptical shape, while the axial dimension of the wire is to be measured perpendicular to the axes or plane of the elliptical shape.

Of course, the present invention also covers embodiments with loops having a shape which is not elliptical but may be circular or defined by a more or less distorted ellipse defining a center and a minimum extension corresponding to the shorter axis and a maximum extension corresponding to the longer axis of an ellipse, since the above considerations also apply to such shapes.

According to embodiments of the present invention, the diameter along the shorter axis of elliptical loops may have dimensions from between 50 µm to about 3 mm and the diameter along the longer axis falls within the range from about 100 µm up to 8 mm.

In one embodiment, the cross section of the wires forming the closed loops may be circular, elliptical or polygonal, preferably rectangular.

By "wire" the present description refers to strings of any material having elastic properties in order to provide any repelling or retracting force upon deformation and which are suited to be shaped as a chain of interconnected loops or other elements like interconnected U-shaped or V-shaped elements.

For practical reasons, it may be that a rectangular cross section of such wires can hardly be obtained by the common methods of producing micro elements, in particular wires, such as by lithographic methods, wherein trenches are formed by anisotropic etching, which trenches are forming the mold for the micro elements and may rather have a trapezoidal than an exactly rectangular cross section so that the cross section of the resulting wires may also be trapezoidal.

For measuring tensile forces, the bridges extending between adjacent loops are preferably extending along an imaginary line of extension of the minor axes of the loops.

A typical micro spring according to the present invention is comprised of a chain of several loops and comprises at least a single loop but preferably at least 3 to 10 loops, while the ends of the spring may be defined by more or less circular rings connected to the first loop and the last loop, respectively, of the chain of loops such that the rings defining the ends of the micro spring may each be attached to a pin, one of which is provided on the carrier the other of which may be provided on the micro gripper or on the slide to which the micro gripper is attached.

The rings forming the ends of the chain of loops should be formed of wires having a substantially larger cross section than the loops of the micro spring in order to avoid any deformation of the rings upon exerting a tensile force on the chain of loops. Also the bridges may have a larger cross section than the wires forming the loops, at least in one dimension.

In one embodiment, the closed loops of the micro spring have an elliptical shape with a ratio b/a of the minor axis b and major axis a, respectively, within the range of 0.1 to 0,9.

Further in one embodiment the minor axes of the elliptical loops are aligned with each other and the loops are connected by bridges between adjacent loops, which bridges are as well aligned along the common line of minor axes.

With such a design, any tensile force between the ends of the spring will distort the elliptical shape by extending the minor axes of all loops, wherein the material of the loops exerts an elastic resilient force to retain the original shape of the loops. Within a substantial range of relative deformation, the retracting force will linearly increase with the extension of the minor axes, wherein the total extension of the spring is the sum of the extensions of all diameters along the minor axes and aligned along a common straight line.

By measuring the total amount of extension between the ends of the spring, the tensile force involved therewith can be determined. The determination of the force/extension ratio may require calibration by means of a separate force measuring device. However, once calibrated and also if producing a plurality of springs with the same geometry and dimension of the wires, the once determined force/extension ratio may be applied to all such micro springs.

The material of which the micro spring is formed, may be any material having sufficient elastic properties in order to generate forces in the desired range of forces and linear relative movement between the ends of the spring. The methods for producing micro elements according to the present invention such as the micro spring and the micro gripper claws include in particular lithography, etching, micromachining in general, in particular silicon micromachining and micromold-ing.

In an alternative embodiment the loops of the micro spring may be arranged such that the major axis of the elliptical loops along the chain are aligned with each other and the loops are connected by bridges between adjacent loops aligned along the common line of major axes. Such spring might reasonably be used for exerting compression forces, wherein it may be required to either design the loops with larger axial dimensions or to provide additional means for keeping the loops arranged in a common plane when any compression forces are exerted on the ends thereof in order to avoid any evading movement of the chain of loops perpendicular to the line connecting the ends of the spring.

The dimensions of loops may typically fall within the range between 10 µm to 5 mm, preferably 50 µm to 3 mm for the diameter RW measured along the minor axis b and within the range from between 20 µm to 10 mm, preferably 100 µm to 5 mm for the diameter RH measured along the major axis a.

The measuring device for measuring the relative displacement may be any device which by itself preferably does not exert any significant extra force on the elements between which the relative displacement is to be measured. In one embodiment, the measuring device is a magnetic encoder which is comprised of a plurality of adjacent oppositely arranged micro magnets (magnetic moments and a magnetic sensor relatively moveable with respect to said magnets with a narrow spacing between sensor and the row of micro magnets. Based on the spacing between adjacent micro magnets, the count of changes in magnetic moment by the sensor may then be calculated as a corresponding relative displacement.

In particular such encoding devices or any optical devices such as interferometric devices may be used for measuring the relative displacement between the micro gripper and the carrier, wherein the respective measurement may of course also occur between the slide and the carrier because the micro gripper is attached to the slide and moves along together with the slide, which also holds for one end of the spring which is attached to the micro gripper. The displacement measurement may also occur with respect to any other device which is in a fixed position with respect to the carrier.

In one embodiment, an actuator may be provided for moving the carrier with respect to any component or materials by the micro gripper.

In one embodiment, the spring is designed for measuring tensile forces, wherein in an idle position, the spring is not biased towards any direction, while any relative displacement between the micro gripper and the carrier would increase the distance between the ends of the spring thereby exerting a tensile force on the spring, causing an elastic deformation of the spring. In the device for handling micro scale objects and including a micro gripper according to the present invention the use of the above defined micro springs consisting of a chain of interconnected closed loops are preferred it would still be possible to use alternative micro springs which may for instance be comprised of a row of interconnected U-shaped or V-shaped elements rather than closed loops.

The slide according to one embodiment of the present invention is linearly guided along the carrier by means of a form locking engagement with respect to a first and second direction mutual perpendicular to each other, while the slide and carrier are freely moveable with respect to each other along a third direction perpendicular to said first and second directions.

A typical connection between a slide and a carrier would for instance be a dovetail connection between the slide and carrier, when of course such dovetail cross section could be replaced by any other form locking cross section such as by means of a bar having a T-shaped cross section received within a groove having a corresponding cross section and formed within a carrier or vice versa.

For providing a minimum of friction between the slide and the carrier, a proper low friction bearing may be arranged between th carrier and the slide, such as a ball bearing or roller bearing and most preferably a magnetic air bearing. Of course, both, the slide and the carrier should have small dimensions and a small mass and inertia within an order of magnitude of the mass and inertia of the combined micro gripper and micro spring. The present invention preferably uses commercially available sliders having a static friction force of at most 400 µN and dynamic friction forces (depending on the relative velocity) below 100 µN, wherein the dynamic friction forces of course depend on the velocity of relative movement.

The present invention is also directed to a preferred method of producing a micro spring to be used in a device according to the present invention, wherein the production method involves a lithographic process, in particular UV-LIGA, which method is further characterized by the use of a photo mask defining a chain of interconnected closed loops, each loop defining a plane, wherein all loops are arranged within a common plane and are interconnected by means of bridges between adjacent loops.

By using a corresponding photo mask, the resulting micro spring obtained by an UV-LIGA-process may have dimensions and designs as described above.

Further features and advantages of the present invention may be derived from the following description of a particular embodiment of the present invention as shown and described with respect to the accompanying drawings, in which:
Figure 1 is a schematic perspective representation of a micro gripper-and-micro spring -combination according to the present invention,
Figure 2 is a top view on the device according to figure 1,
Figure 3 is a side view of the device shown in figure 1,
Figure 4 is a series of cross-sectional views, wherein the cross-sectional lines are shown in another side view on the bottom of figure 4,
Figure 5 shows a photograph of a micro spring and a schematic representation of a single loop and a cross-section thereof,
Figure 6 visualizes the UV LIGA- process for producing a micro spring
Figure 7 is a photograph showing a top view of a micro spring including micro rings and additional photographs of details of the spring and wires forming the loops and bridges,
Figure 8A shows the spring mounted on a slider in a perspective view and figure (B shows a top view of the spring mounted on a slider and
Figure 9 shows a graph of calibration data of the micro spring shown in figures 8A and 8B

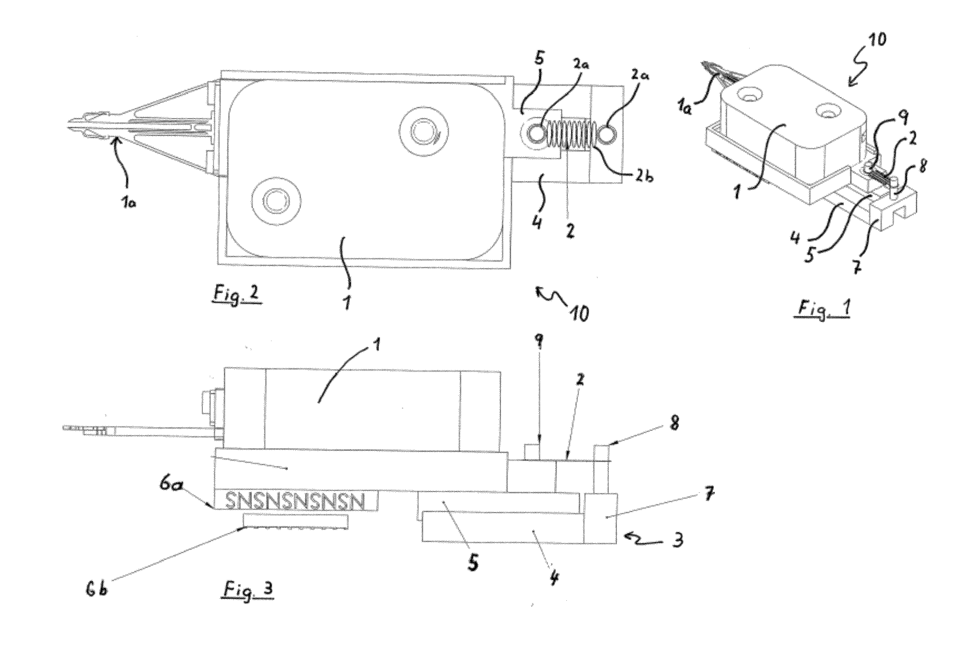

In figure 1, the micro handling device is indicated by reference numeral 10. The handling device 10 is comprised of a micro gripper 1 and a low-friction slider which in turn is comprised of a carrier 4 and a slide 5. The micro gripper 1 is mounted and fixed to the slide 5. At the end of the carrier 4 there is provided a stopper 7 and a pin 8 is projecting upwards from the stopper 7 while another pin 9 is projecting upwards from the rearward end of the micro gripper 1. Of course, the actual micro gripper, i. e. the member acting on objects having dimensions on a micrometer scale, are the gripper claws 1a while the remaining actuator portion of the microgripper 1 which is mounted on the slide 5 does not necessarily have any micro properties, I e. does have to be produced by specific micromechanical production methods.

The micro spring 2 is better visible in the top view of figure 2, further showing that the ends of the spring 2 are formed by two rings 2a which are connected to the chain of elliptical loops 2b which are forming the actual micro spring 2. The wires of which the rings 2a are formed have a much larger cross section than wires of which the loops 2b are formed. The rings 2a are thus more rigid and deformable when fitted about the two pins 8 and 9, respectively, so that any relative movement between the micro gripper 1 and the carrier 4 will cause a corresponding deformation of the spring 2, i.e. a deformation of the closed loops 2b. The present device is particularly designed for measuring tensile forces, which means that the starting or idle position, in which the spring 2 is not biased in any direction, only relative movements between the slide 5 and the carrier 4 and thus the two pins 8 and 9 will only cause an increasing distance between pins 8 and 9 and thus an extension of the spring 2, so that a tensile force is generated between the micro gripper 1 and the carrier 4 or stopper 7.

Further visible in the top view of figure 2, the micro gripper 1 also comprises gripping clause 1 a for grasping any appropriate micro object which for instance may be a thin film.

The relative displacement between the micro gripper 1 and the carrier 4 is measured by means of a magnetic encoder, which is comprised of a magnetic sensor, in particular a Hall sensor, which is arranged in close distance and vis a vis a magnetic multipole strip (comprising a series of micro magnets as schematically represented as a series of capital letters "S" and "N" representing magnetic poles magnetic multipole strip). The multipole strip is directly or indirectly attached to the micro gripper 1 and movable together therewith, while the encoder sensor 6b is at a fixed position with respect to the carrier 4. Accordingly, any relative displacement between the micro gripper 1 and the carrier 4 will be sensed by the magnetic encoder which simply counts the number of magnetic poles passing the sensor.

The magnetic poles are closely stacked in micrometer distances which allows a corresponding accuracy of measuring the displacement.

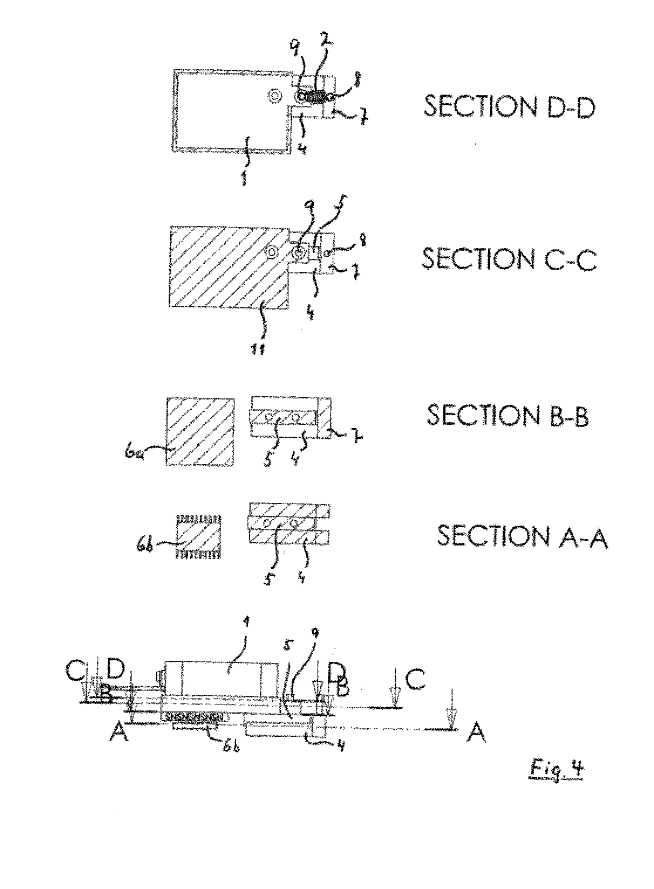

Figure 4 shows some more details of the device according to figures 1 and 3 by means of another side view shown on the bottom of figure 4, and cross-sectional views as indicated by capital letters "A-A" to "D-D" taken at different levels. In section A-A, a top view of the carrier, the slide and the magnetic sensor is visible, section B-B again shows the carrier and slide together with a block 6a representing the linear array of multipole magnetic strip, section C-C shows a connecting element between the micro gripper 1 and slide 5 and finally section D-D shows the body of the micro gripper 1 and the spring rings 2a mounted about the two pins 8 and 9, respectively.

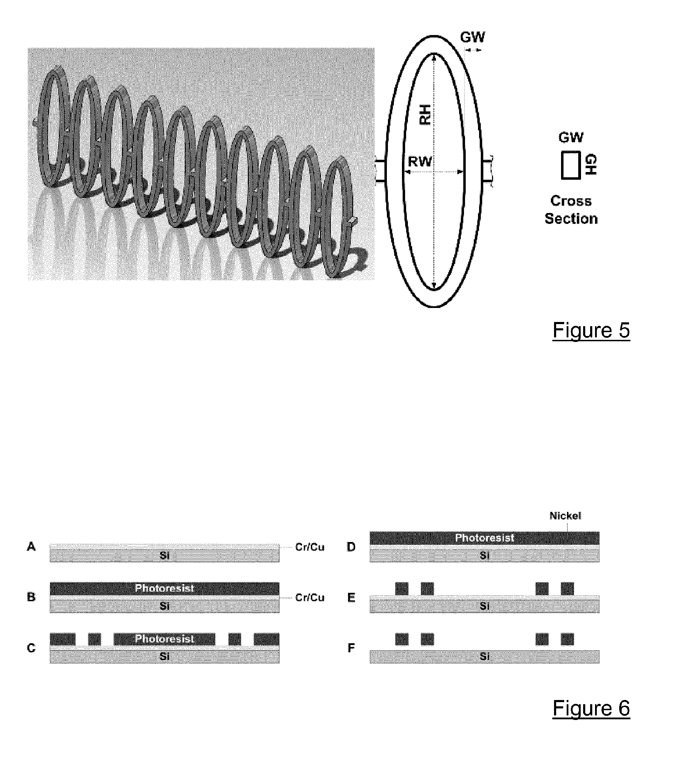

Figure 5 illustrates the schematic design of the micro spring which is made of a chain of elliptical rings. In this paper, the transverse diameter (major axis x 2) and the conjugate diameter (minor axis x 2) of the ellipses in the micro spring are called a ring height (RH) and a ring width (RW), respectively. The cross section area of the ring is called a micro spring gauge and its dimensions are named as a gauge width (GW) (radial dimension) and a gauge height (GH) (axial dimension). The links which connect the elliptical rings together have the same cross section dimensions as the micro spring gauge.

Based on the values reported in the literature for the Young's modulus (*E* =171.5 GPa) and for the Poisson's ratio (v = 0.3) of EINi, the effect of variations in RH, RW, GH, GW, the number of rings and the length of the connection between the rings on the maximum stress and the displacement were studied using ANSYS simulation software (Canonsburg, Pennsylvania, U.S.A.). Based on the simulation results, the RH of 1600 µm, RW of 250 µm, GH of 50 µm and GW of 30 µm are the selected dimensions for the fabrication of the micro spring. It is desirable to achieve the maximum possible elastic range for a micro spring under a particular load, such as 20 mN, which leads to maximum possible linear deformation, and therefore maximum possible sensitivity for the sensor. The maximum stress in a micro spring with GH of 50 µm and GW of 30 µm under a 20 mN load is 0.77 GPa. Considering 1.1 GPa yield strength for the EINi, the stress value of 0.77 GPa for the selected geometry allows a reasonable linear range for the micro spring with a 30% safety threshold that keeps away the micro spring from plastic deformation. Simulations also indicate that the effect of the length of connections between two rings on the displacement is negligible, and increasing the number of rings increases the displacement linearly.

A micro spring was fabricated using UV-LIGA. Figure 6 illustrates the fabrication process: First, a Cr/Cu layer is sputtered on a Si wafer), then positive photoresist AZ®50XT is spun on the Cr/Cu layer to the height of 50 µm. Next, using a mask and the UV-Lithography process trenches are made in the photoresist. The nickel specimen layer is electroplated in 50°C with a current density of 10 mA/cm² to the desired height of 50 µm; the main composition of electroplating solution is nickel sulfamate Ni(NH₂SO₃)₂.6H₂O with pH of 3.9. After electroplating, the positive photoresist is removed using NaOH solution and the Cr/Cu layer is back-etched using NH₃.H₂O.H₂O₂ solution.

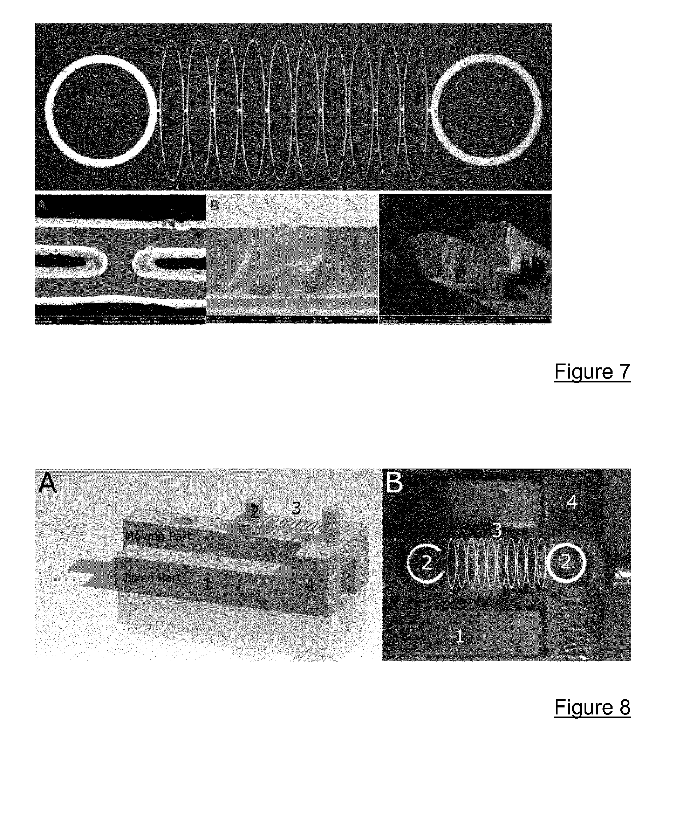

The geometry of the fabricated micro springs was measured using a Scanning Electron Microscope (Zeiss AG-ULTRA55, Germany). Figure 7 shows the Scanning Electron Microscope (SEM) images of a fabricated EINi micro spring and its cross sections. The SEM images in 7B and **Fehler! Verweisquelle konnte nicht gefunden werden.**7C illustrate that the cross section of the fabricated micro spring specimen is a trapezoid instead of an ideal rectangle. The trapezoidal cross section is caused by the scattering of the UV light during the lithography process. The side walls of the trenches in the photoresist are not parallel which is a drawback of using AZ®50XT thick photoresist in UV-Lithography. Even though micro springs are not ideal because of these geometrical defects, it is still possible to use them to prove the proposed force sensing concept. The fabricated micro spring is composed of ten elliptic sensing rings and two circular mounting rings (1 mm in diameter) in the ends of the spring.

To determine the suitability of micro springs according to the present invention, the linear force-displacement range of the micro springs needs to be determined. A low friction precision linear slider (IKO, Japan) [Item 1 in figure 8 A] with coefficient of rolling-resistance of 0.001 is used as a guide-way for the micro spring. Two pins [Item 2 in figure 8A] with a diameter of 0.9 mm are used to mount the micro spring [Item 3 in 8]. One pin is mounted on the fixed part of the precision linear slider (PLS), so called the stopper [Item 4 in 8], and another pin on the moving part of the PLS. The stopper is an in-house made component and it is not an original part of PLS. Using the mounting rings, the micro spring is mounted on the PLS pins by using magnetic tweezers.

In order to characterize the proposed force sensor performance, a 10 mN FT-S10000 force sensor (FemtoTools AG, Switzerland) is mounted on a SLC-1730 micro positioner (Smaract GmbH, Germany) and it is aligned with the PLS slider. From now on the SLC-1730 micro positioner will be called a linear actuator in this description. The moving part of the PLS slider and the FT-S10000 force sensor probe are connected using a small rod.

The linear actuator has an integrated position sensor, an optical encoder, with the resolution of 100 nm. Since the FT-S10000 force sensor probe and the PLS slider are connected, the change in the position of the FT-S10000 force sensor probe represents the displacement of the micro spring. Another option to measure the displacement of the micro spring is using a sequence of images from top-view. The first approach, however, offers higher resolution, thus it has been used in these experiments.

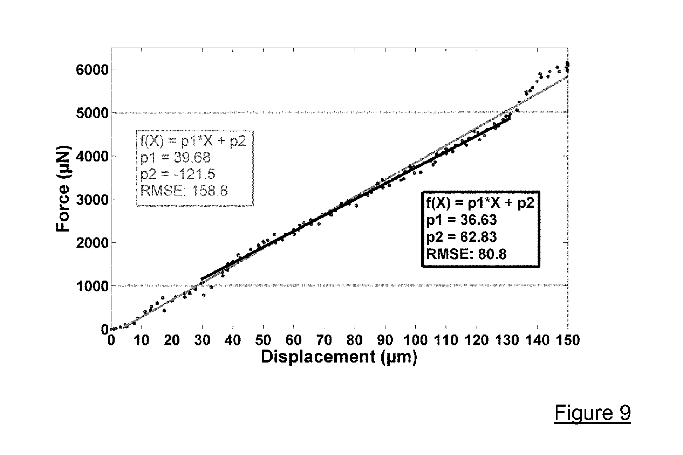

The results from the experiments as shown in figure 9 demonstrate that the proposed force sensor using EINi micro spring and the PLS can be used as a new tool in micro-force sensing applications for forces higher than a couple of thousands of micro-Newton. In the proposed force sensing approach, the side effects of friction forces on the force measurements are small enough to make this approach reasonable. Even though the force range of the micro spring fabricated in the investigated embodiments is limited to 6 mN, the proposed approach allows for the fabrication of EINi micro springs for the forces up to tens of millinewtons for micro-tensile testing of various materials. There are three methods to increase the linear force range of EINi micro springs: changing the plating temperature, changing the current density and changing the radial thickness GW of the wires. According to reported results, 20 °C change in plating temperature affects Young's modulus by 15%, and 25 mA/Cm² change in current density affects Young's modulus by more than 50%. Indeed, the most effective way to change the linear force range of the micro spring is changing the GW which affects the force range with three orders of magnitude. The benefit of changing the force range of EINi micro spring by either the plating temperature or the current density is the possibility of keeping the micro spring geometry constant. Thus, when a change in the force range is required only the spring should be changed and the rest of components in the micro-force sensor can remain the same.

Use of EINi micro springs based force sensor for micro-tensile testing applications is a new approach compared with the other approaches reported in the literature such as load cells, servo controlled balance and eddy-current based force sensors. The average sensitivity of the developed force sensor is 36.63 µN/µm.

## Claims

1. micro handling device handling micro objects and measuring forces exerted on said micro objects, including a micro gripper (1) and a force sensor connected to said micro gripper **characterized in that** the device includes a micro spring (2) as the force sensor.

2. Micro handling device (10) according to claim 1, **characterized by** the following combination of features
- the micro gripper being (1) attached to a slide (5), the slide (5) being linearly moveable with respect to a carrier (4)
- a micro spring (2) as defined above and having two ends, one end being attached to the micro gripper (1) and the other end attached to the carrier (4), an imaginary line connecting the ends of the spring (2) extending along the direction of linear movement of the slide (5), and
- a measuring device (6a, 6b) measuring a relative displacement between the micro gripper (1) with respect to the carrier (4) upon any force acting on the micro gripper along the direction of relative displacement, wherein the amount of displacement from an idle position is an indication of the force exerted on the micro gripper.

3. Micro handling device (10) according to claim 1 or 2, **characterized in that** the micro spring (2) is comprised of a chain of interconnected closed loops arranged in a common plane.

4. Micro handling device (10) according to claim 1 or 2, **characterized in that** the closed loops have an elliptical shape with a ratio b/a of the minor axis b and major axis a, respectively, within the range of 0.1 to 0.9.

5. Micro handling device (10) according to claim 1 or 2, **characterized in that** that the minor axes of the elliptical loops are aligned with each other and the loops are connected by bridges between adjacent loops and aligned along the common line of minor axes.

6. Micro handling device (10) according to any of the preceding claims, **characterized in that** the major axis of the elliptical loops along the chain are aligned with each other and the loops are connected by bridges between adjacent loops aligned along the common line of major axes.

7. Micro handling device (10) according to any of the preceding claims, **characterized in that** the Loops are formed by wires having a cross section with a radial and axial dimension from between 10 to 500 µm.

8. Micro handling device (10) according to any of the preceding claims, **characterized in that** Loops being formed of wires having a continuous cross section along their longitudinal extension.

9. Micro handling device (10) according to any of the preceding claims 3 to 8, **characterized in that** the loops are connected by means of bridges having about the same cross section as said loops

10. Micro handling device (10) according to any of the preceding claims, **characterized in that** the micro spring is formed by means of silicon micromachining including wet etching or by a lithographic process, such as LIGA (lithography, galvanization, and moulding), in particular UV-LIGA.

11. Micro handling device (10) according to any of the preceding claims, **characterized in that** the micro spring is integrally formed of metal, such as CU or AU, in particular electroplated Nickel.

12. Micro handling device (10) according to any of the preceding claims, **characterized in that characterized in that** the loop diameter RW along the minor axis is from between 10 µm to 5 mm and the loop diameter RH along the major axis is from between 20 µm to 10 mm

13. Micro handling device (10) according to any of the preceding claims, **characterized in that** the cross section of wires circular, elliptical or polygonal, preferably rectangular.

14. Micro handling device (10) according to any of the preceding claims, **characterized in that** actuator is provided for moving the carrier with respect to a micro element grasped by the micro gripper.

15. Micro handling device (10) according to any of the preceding claims, **characterized in that** The slide which is linearly guided along the carrier by means a form locking engagement with respect to a first and a second direction mutually perpendicular to each other, while the slide and carrier are freely moveable with respect to each other along a third direction perpendicular to said first and second directions.

16. Micro handling device (10) according to any of the preceding claims, **characterized in that** a Ball bearing or magnetic air bearing is arranged between the slide and the carrier,

17. Microspring for use in a micro handling device for handling and/or characterizing materials and components having micro scale dimensions, the device including a micro gripper, **characterized by** a spring design which is formed by chain of interconnected closed loops.

18. Method of producing a micro spring for the use a force sensor in a device for handling micro objects according to any of the preceding claims, by means of UV LIGA **characterized by** the use of a photomask defining a chain of interconnected closed loops each loop defining a plane, wherein all loops are arranged within a common plane and interconnected by means of bridges between adjacent loops.
